# EUROPEAN PATENT SPECIFICATION

(11) **EP 1 279 068 B1**
(45) Date of publication and mention of the grant of the patent: **09.07.2014**
(21) Application number: 01928066.8
(22) Date of filing: 04.05.2001
(51) Int. Cl.: G03F 7/00, G03F 7/20, B05D 1/04

(54) **Method and apparatus for nanostructures fabrication**
Verfahren und Vorrichtung zur Herstellung von Nanostrukturen
Procédé et dispositif pour la fabrication de nanostructures

(30) Priority: 04.05.2000 GB 0010800; 03.11.2000 GB 0026958
(43) Date of publication of application: 29.01.2003
(73) Proprietor: QuNano AB, 223 70 Lund (SE)
(72) Inventor: DEPPERT, Knut, Wilfried, S-224 77 Lund (SE); MAGNUSSON, Carl, Martin, Hall, S-222 40 Lund (SE); SAMUELSON, Lars, Ivar, S-217 74 Malmö (SE); KRINKE, Thomas, Johannes, 41462 Neuss (DE)
(74) Representative: Neij & Lindberg AB
(86) International application number: PCT/GB2001/001972
(87) International publication number: WO 2001/084238

(56) References cited:
- EP-A- 0 431 249
- EP-A- 0 480 183
- DONALD D K: "CONTACT ELECTRIFICATION AND LICHTENBERG FIGURES ON INSULATORS" PROCEEDINGS OF THE NATIONAL ACADEMY OF SCIENCES OF THE USA, NEW YORK, NY, US, October 1968 (1968-10), pages 170-174, XP000952369
- CHEN I: "DEVELOPMENT OF ELECTROSTATIC IMAGES WITH POLARIZED TONERS" PHOTOGRAPHIC SCIENCE AND ENGINEERING, SOCIETY OF PHOTOGRAPHIC SCIENTISTS AND ENGINEERS. WASHINGTON, US, vol. 26, no. 3, May 1982 (1982-05), pages 153-157, XP000946922
- UCHIHASHI T ET AL: 'Charge storage on thin SrTiO3 film by contact electrification' vol. 33, no. 9B, SPEC. ISSUE, pages 5573 - 5576, XP002149344

## Description

This invention relates to a method of forming structures of small dimensions, for example of nanometer dimensions - commonly known as nanostructures - and also relates to methods involving interaction of small particles, especially nanometer dimensioned particles with material surfaces.

Hitherto, small-scale photonic or electronic devices have been fabricated using photolithographic processing techniques. As sizes are reduced, it becomes difficult to form the individual geometric features of these devices at a sufficient degree of resolution due to the need to employ radiation of ever-shorter wavelengths to expose the photoresist.

A process that presses a mould into a thin thermoplastic polymer film on a substrate to create vias and trenches with a minimum size of 25nm is disclosed in "Imprint of sub-25nm vias and trenches in polymers" Chu et al, Applied Physics Letters 67(21), 20 November 1995, pages 3114-3116.

Nanometer-sized metal and semiconductor particles (nanoparticles) may be regarded as potential components for photonic or quantum electronic devices. Fabrication of these devices requires not only deposition but also positioning of nanoparticles on a substrate. There are many different ways of creating nanometrescale structures using particles or clusters as building blocks, such as deposition from a suspension using capillary forces, which gives two- and three-dimensional arrays of crystal-like structures of particles.

Nanometer-scale chains of metal clusters have been fabricated with a resolution better than 200 nm. They nucleate at the boundary of the substrate and lines of photoresist during deposition of copper - "Microfabrication of nanoscale cluster chains on a patterned Si surface", Liu et al, Applied Physics Letters, 5 Oct 1995, p 2030 - 2032.

"An arrangement of micrometer-sized powder particles by electron beam drawing", Fudouzi et al, Advanced Powder Technol., 1997, vol.8, no. 3, pp251-262, reports that electrically charged lines on the scale 20 µm may be written in an insulating surface. It is shown that charged silica spheres (5µm diameter) in a suspension can be controllably directed towards such charged lines.

On the topic of electrically charging surfaces, "Electrostatic writing and imaging using a force microscope" Saurenbach, IEEE Transactions on Industry Applications, Volume 28 No. 1, January 1992, page 256 discloses the use of an electrostatic force microscope having a tungsten microscope tip, arranged to touch a polycarbonate surface with a small voltage to transfer charge to the surface in order to produce "charge spots" of micrometer dimensions.

"Charge storage on thin Sr Tr O3 film by contact electrification" Uchiahashi et al, Japanese Journal of Applied Physics, Volume 33 (1994), pages 5573-5576 discloses charge storage on thin film by contact electrification, by using an atomic force microscope. It was possible to discriminate between charge dots spaced about 60 nm apart. The process is intended for non-volatile semiconductor memories.

Document EP 0 480 183 describes a method for producing fine line patterns on insulating surfaces utilising a conductive spring-like cantilever having a pointed tip which is in proximity to the surface to be offered.

### Summary of the Invention

It is an object of the present invention to provide an improved method by which devices having very small geometric features may be fabricated.

The concept of the present invention is to induce an electric charge in very small, as small as nanometric-dimensioned areas, on a surface, preferably by contacting a metallic tool in a controlled manner on an insulating substrate. As a second step in the invention, nanometric-dimensioned particles in an aerosol or in liquid phase are then influenced by the regions of electric charge on the substrate in order to be deposited on the substrate or otherwise to interact with the substrate as explained below.

In a first aspect, the invention provides a method for creating nanostructures as defined in claim 1.

In a second aspect, the invention provides apparatus comprising tool means for contacting one or more regions of predetermined shape on a surface of a first material in order to transfer electric charge thereto, and means for permitting particles of a second material to flow in the vicinity of said regions, to interact in a predetermined manner with said regions.

In a further aspect, the invention provides a method, comprising the steps of forming one or more electrically-charged regions of predetermined shape on a surface of a material, providing particles of nanometric dimensions, and permitting the particles to flow in the vicinity of said regions to interact in a predetermined manner with said regions.

For the purposes of the present specification, "particles of nanometric dimensions" is intended to means particles having a diameter of 300 nanometers or less. As preferred for most applications, the particle diameter is 50 nanometers or less, and as further preferred, in some applications, for example optoelectronics, the particle diameter is 10 nanometers or less.

The tool means may be a press or stamp having a contoured surface of dimensions as large as millimeters or as small as nanometers, which is arranged to contact the surface of the substrate, and has a configuration conforming to the desired pattern or configuration of electric charge to be deposited on the substrate. The press or stamp may be of a rigid material, or a resilient material, e.g. a metal coated rubber material.

A significant advantage of employing a stamp is that a complex configuration of electrically charged regions of predetermined shape, extending over a wide area, may be formed in a single operation. The process of the invention is therefore very much faster to carry out than other methods, such as electron beam drawing or writing.

Alternatively the tool may take the form of a needle, rod or other elongate object which is drawn across the surface in a desired path to create the desired pattern of electric charge. The tool may be the tip of a scanning probe microscope. The tool will usually be of metal but can be of any other suitable rigid material having a work function which is such in relation to the work function of the first material to permit charge flow to the surface of the first material. The first material is commonly an insulating material, but may be semiconducting or of any material which is such as to hold the applied electric charge for a sufficient length of time to permit the method of the invention to take place.

In addition to the locally charged regions, deposition of the second material may be assisted by application of an electrostatic precipitation field.

Preferably, the particles of the second material have a second electrical charge of opposite sign to the first. Alternatively, the particles of the second material may be of the same sign as that of the first electric charge, and the pattern of the deposited second material is determined by the repulsion from the one or more electrically charged regions.

The requirement that the particles be charged may in some cases be relaxed - particles may become polarised in an electric field and will be attracted towards electrostatically charged objects due to an electric field gradient.

In another application, electrically neutral nanometric particles may be projected against a surface, each to absorb one or more charge carriers, and to rebound from the substrate in an electrically charged condition.

The particles of a second material may be formed by any suitable process. A preferred process of producing the particles in aerosol form is described below. Alternatively other processes such as laser ablation may be employed.

### Brief description of the drawings

Preferred embodiments of the invention will now be described merely by way of example with reference to the accompanying drawings, in which:
Figure 1 is a schematic diagram illustrating the method of the invention;
Figures 2a to 2c is a sequence illustrating the application of electrical charge to receptor regions of an insulating surface in accordance with the invention;
Figure 3 is a schematic view of a deposition chamber (precipitator) for an aerosol nanoparticle generator, for the method of the invention;
Figure 4 illustrates, in diagrammatic form, an aerosol nanoparticle generator, described in our co-pending PCT Application No. GB98/03429;
Figures 5a-c to 9 are scanning electron micrographs of surfaces of materials having particulate deposits thereon, formed in accordance with the invention; and
Figures 10 - 19 are schematic drawings showing various examples of application of the present invention.

### Description of the preferred embodiments

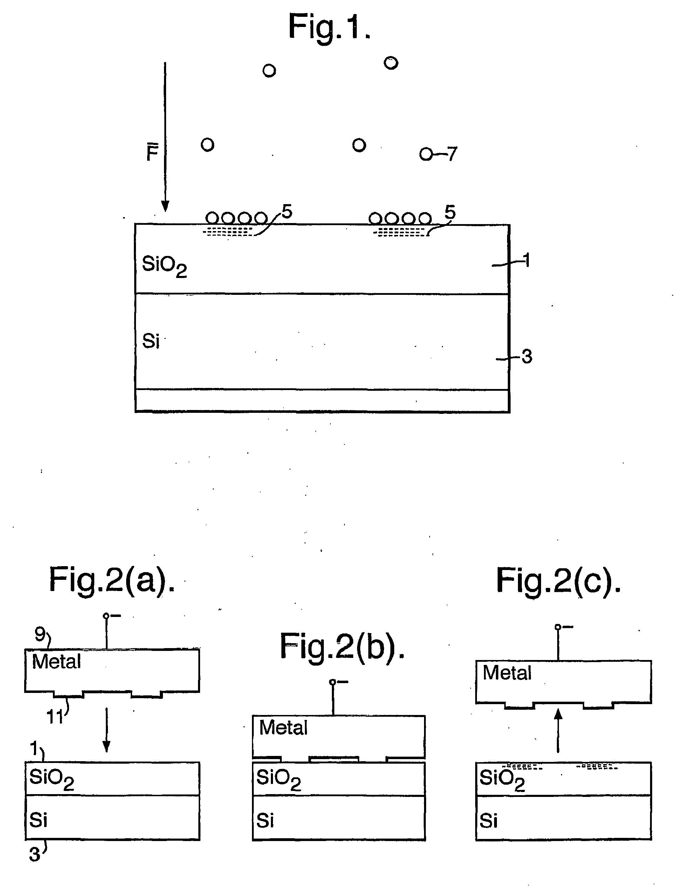

Referring now to the Figure 1 of the drawings, the surface of a silicon wafer 3 is oxidised to produce a silicon dioxide layer 1, and localised regions 5 of negative charge are imprinted on the surface. Nanoparticles 7 formed in an aerosol unit are impressed with a positive charge and are attracted to the locally charged regions 5 of the silica surface layer, with the assistance of a local electric field F.

One method of applying the local charge to the surface is illustrated in Figure 2a to 2c. A nanoprinting stamp 9 is made from a conducting material (or from an insulator coated with a metal), and is brought into contact with the insulating surface 1. The stamp 9 has protrusions 11 formed on its contact surface in a predetermined configuration. The width of these protrusions may range from dimensions of nanometers up to the macroscopic millimetre range, preferably fabricated by electron beam lithography. The height of the protrusions is not material to the region definition. After contact, localised charged regions are left on the surface 1 of the substrate exactly mirroring the dimensions and structures of the stamp protrusions.

The basis of this method is that charges cross the interface of an insulator and a metal brought into contact. After the metal is removed, a charge is retained on the insulator. The sign and amount of charge transferred depends approximately linearly on the work function or Free Energy of the metal in relation to the work function or Free Energy of the insulating substrate. The amount of charge may be increased by providing a potential difference between the metal and the insulator. It is estimated that, with the method of this preferred embodiment, 10⁵ charges per square micrometer or less are transferred.

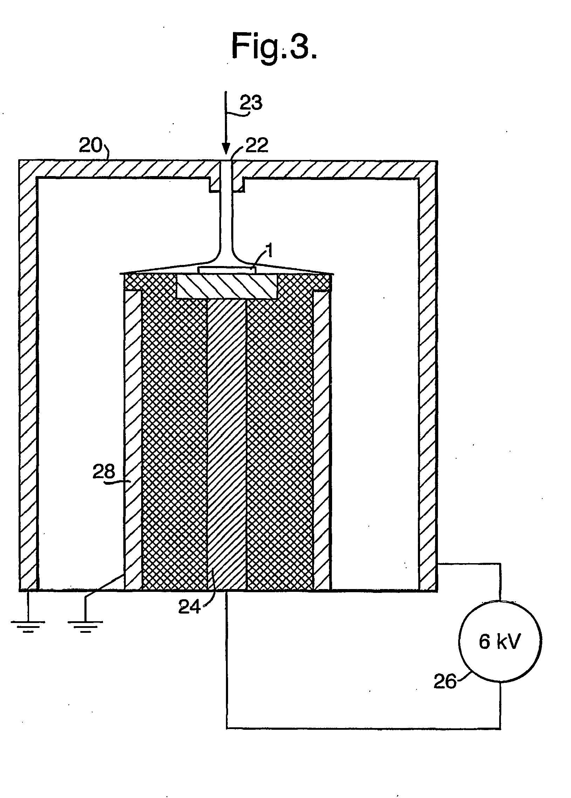

The substrate, which now has a pattern of charge on its surface 1, is placed in a deposition chamber or precipitator for an aerosol nanoparticle generator as shown in Figure 3. The generator produces particles with a controlled charge, either positive or negative. If the aerosol particles have a polarity opposite to that of the charge on the surface of the substrate, the particles will preferentially deposit where the substrate is charged (Fig. 1), whereas particles with the same polarity as the surface charge pattern will be repelled from the pattern, and are deposited in the spaces between the locally charged regions. In the case of no applied electric field, particles with opposite charge states will still deposit where the substrate is charged, whereas particles with the same polarity as the surface charge pattern will not be deposited.

Further processing steps may then be undertaken to fix the particles permanently to the surface.

Referring to Figure 3 there is shown a chamber 20 which is electric grounded having an inlet 22 in its upper wall for receiving particles 7 in the form of an aerosol. A electrode 24 in the chamber is connected to a source of potential 26 in order to generate an electric field between the electrode and the walls of the chamber. The electrode 24 is mounted on an insulating tube 28. The electrically charged sample 1 is placed on the upper surface of the electrode 24. The sample is a distance of some centimetres from the opening 22.

In use, particles 23 entering the chamber through opening 22 flow towards sample 1. The electric charge on the sample as shown in Figure 1 may be sufficient to attract the particles for deposition. However, as shown, the deposition may be assisted by the electric field existing between electrode 24 and the walls of chamber 20.

In this case, the particle deposition may take place (a) by attracting particles of a different polarity to the charged regions and (b) by deflecting particles from the charged regions. In the first case particles are deposited at the charged regions but are also deposited on areas in between the regions with lower density and randomly. This is dependent on the distances between the regions the strength of the macroscopic electric field applied, the particle size, and e particle speed in the gas flow. In the second case particles would only be deposited in between the charged regions.

Furthermore, this embodiment may be adapted so as to use instead of particles in an aerosol, colloidal particles from the liquid phase, which will also be attracted by the charge patterns.

Other methods of bringing the particles close to the surface, which do not rely on an macroscopic electric field, may be used, e.g., inertial impaction or thermophoresis.

Whilst the creation of charge patterns can easily be demonstrated for insulating surfaces, the method may also be used for semiconductor and metal surfaces, although the amount of charges and the time duration of charges might be smaller as compared with insulating surfaces.

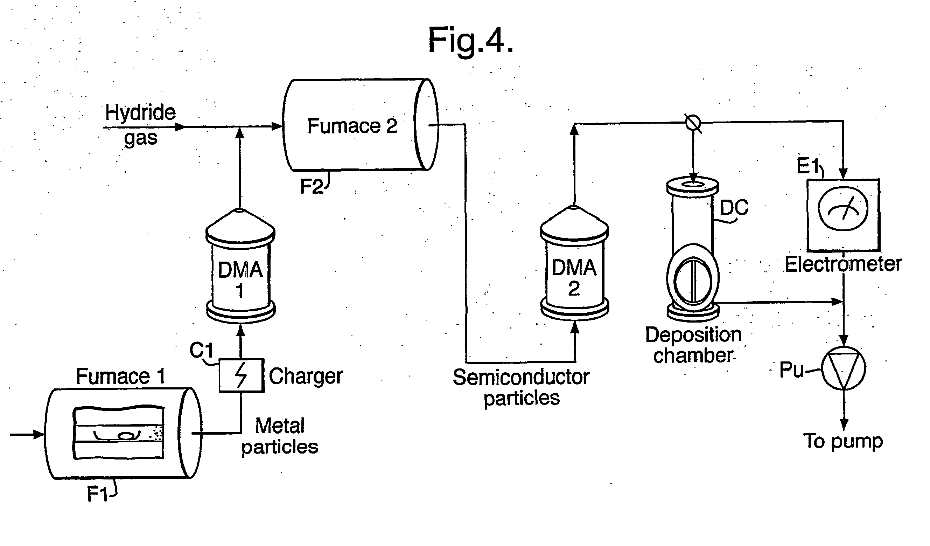

In order to generate electrically charged particles for depositing on the substrate surface in the apparatus as shown in Figure 3, the apparatus of Figure 4 is employed in this embodiment. This is an aerosol generator capable of producing an aerosol with a volume flow of 1680cm³/min and a particle concentration of around 5x10⁵cm⁻³ was used for particle generation. In Figure 4, a furnace F1 generates metallic particles by sublimation. An electrical charger C1 is placed after the furnace to charge the aerosol particles. Size selection takes place in a differential mobility analyser DMA1. DMA apparatus exploits the fact that the electrical mobility of singly charged particles is a monotonically increasing function of particle size. While sending a flow of electrically charged particles in a perpendicular electric field, the field causes particles to be attracted to one capacitor plate. Particles with higher electrical mobility will be precipitated on the nearest portion of the plate and those with lower mobility will be carried along with the main flush flow. Only those with the correct mobility, and hence particles size, will be attracted to the facility of the sampling slit where they are swept out by the gas stream flowing through the slit. The DMA can produce particles with a closely controlled dimension, to within a standard deviation of a few percent. These particles are conducted to further furnace F2 where they are mixed with a hydride gas in order to produce further particles of a further composition. These particles are subject to a close dimensional control in a further DMA2. For a given particle diameter, a distribution of diameters of ±0.2 of the diameter is achieved. The diameter of the particles may be as small as 5nm, or even molecular size. These particles are conducted to a deposition chamber DC, which is as shown in Figure 3. An electrometer E1 and a pump Pu are connected to measure the particle concentration and to create a gas flow therein for flowing the particles into the deposition chamber or precipitator.

The carrier gas is ultra pure nitrogen at ambient pressure and room temperature. Due to the generation process, the particles carry either one positive or one negative charge. For deposition, the aerosol flows into the apparatus shown in Figure 3. A stagnation point flow was established over the substrate. An electric field guides the charged particles towards the substrate surface where they are deposited. In the absence of this field, the particles follow the streamlines of the carrier gas and no deposition occurs. Thermal wet oxidised silicon (111) with oxide thickness of 500nm and a plane surface were used as substrates. The silicon was p+ doped with 0.01 to 0.02 Ω-cm resistivity. No special cleaning process was carried out except that of removing coarse particles by blowing with nitrogen.

As an alternative to using a stamp, contact charging of the substrate surfaces may be carried out with a stainless steel needle that is slid over the substrate surface without applying pressure, both needle and substrate being earthed

For sample evaluation, scanning electron microscopy (SEM) was used to obtain the particle arrangement on the substrate surfaces.

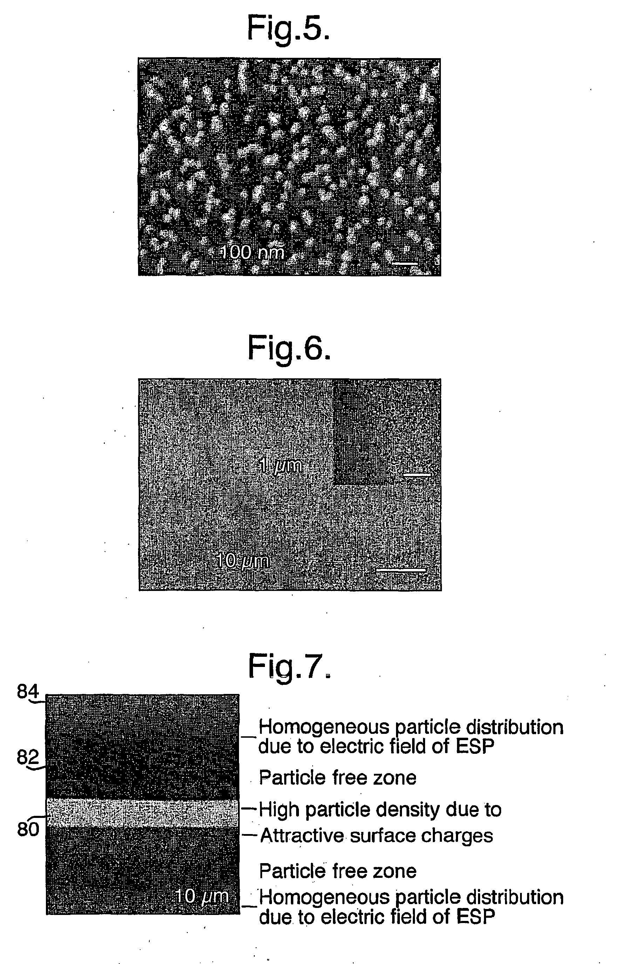

Fig. 5 shows the homogeneous distribution of particles that is obtained after deposition of negatively charged, 30nm indium particles in the homogeneous electric field of the electrostatic precipitator with 150kV/m electric field strength. The particles are attracted to the surface by the macroscopic electric field. Their macroscopic distribution is homogeneous over the whole sample area. The same behaviour is obtained for the deposition of positively charged particles in a negative field.

When negatively charged particles are deposited at 150kV/m on a substrate, which has previously been patterned with lines of negative surface charges, as shown in Figure 6, particle-free zones show up within the homogenous particle distribution. Fig. 6 is a scanning electron micrograph that shows that these zones are approximately 10µm in width. At their border is a narrow transition region (shown in the inset) with a width of around 300nm in which the particle density increases from zero to the mean density found on the rest of the substrate. The pattern of particle free zones observed after the deposition corresponded to the pattern applied with a steel needle. This indicates a negative charging of the contact area between substrate and needle.

In the case of deposition of positively charged particles with a homogeneous electric field of ∼150 kV/m on a negative charged substrate, particles are deposited as shown in Figure 7 in an approximately 10µm line 80 lying in the centre of a 200µm particle free zone 82. The particle density within this line 80 is higher by a factor of approximately 5-10 compared to the mean density on the rest of the sample. Again, the borders of the different areas are very sharp. The lines were situated where the steel needle traversed the substrate. In regions 84, remote from line 80, deposition by electrostatic precipitation occurred.

For the fabrication of microelectronic components, it is often desirable to cover certain areas of a substrate selectively with a single material, such as gold, while the rest has to remain clean. This means that it is preferable to avoid the uncontrolled coverage of the substrate caused by the electric field of the electrostatic precipitator. Depositing positively charged particles on a charged substrate with the electrostatic precipitator turned off, i.e. no electric field applied, the surprising result is that the amount of charges on the substrate is sufficient to attract the particles from the gas flow. This means that the deposition becomes very selective and only the parts of the sample that are charged will be covered with particles. Line width of approximately 10µm can be achieved. When the same process was carried out with negatively charged particles no particles at all were deposited.

When handling the substrate under ambient conditions the surface will have a contamination layer consisting mainly of water. During the contact electrification, charges are trapped in the silicon oxide surface as well as in the contamination layer. The latter are mobile and can move within the contamination layer. This leads to a broadening of the charge patterns on the surface. Using surfaces without this contamination layer improves the sharpness of the boundary between charged and non-charged regions. As preferred therefore, measures and means are employed to remove or prevent the formation of the water contamination zone, such as heating the substrate in a water-free atmosphere.

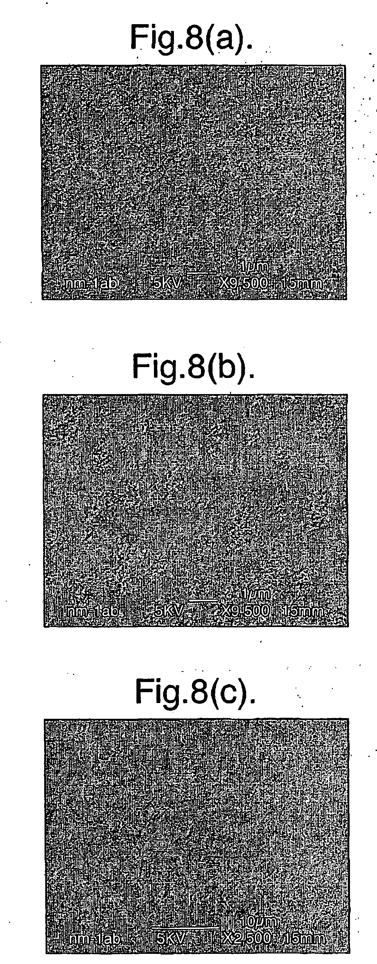

In one specific embodiment, silicon with a 1µm layer of oxide was pressed against a Compact Disc (CD) master. A CD master is a metal plate with protrusions corresponding to where the depressions in the CD will be. These protrusions are on the scale of 1µm. The result after aerosol particle deposition is shown in scanning electron micrographs (Figures 8a to c). This demonstrates that particles gather on the contact electrified spots. Figure 8a is the case for a uniform deposition with no locally charged regions. Figure 8b, on the same scale as Figure 8a, shows the deposition on locally charged regions by pressing with the CD master. Figure 8c is a reduced scale view of Figure 8b.

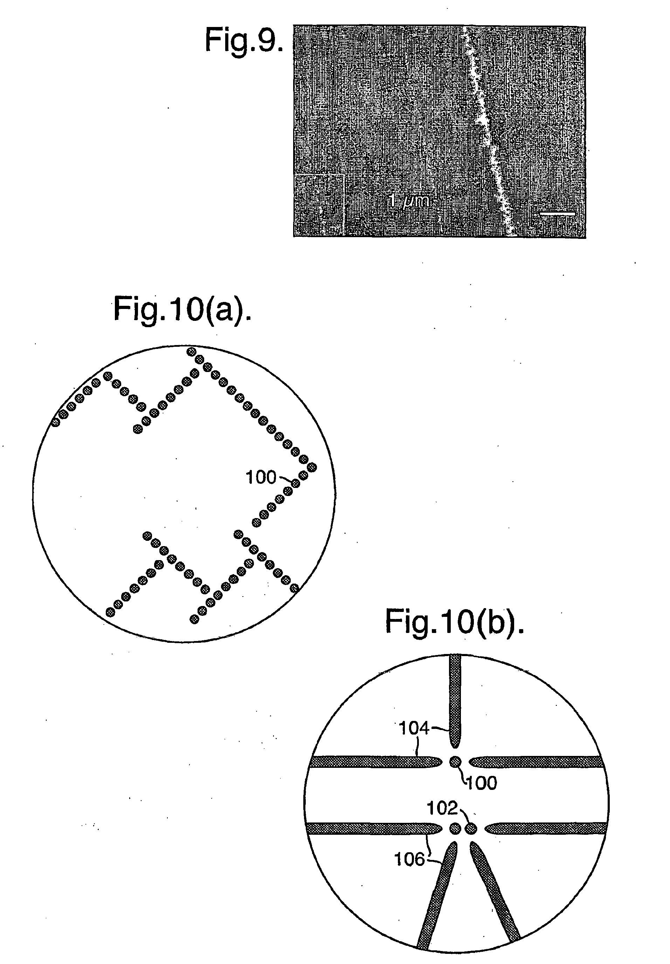

In accordance with a specific embodiment of the invention, as shown in Figure 9, lines were made by gently sliding a metal needle against an insulating (SiO₂) surface. This shows that it is possible to collect positively or negatively charged particles with or without applying an external electric field in the precipitator. A resolution below 50nm may be attained.

It is possible to cover a surface with nanometre resolution with substances that can be electrically charged and dispersed in a carrier gas. The size range of the building blocks ranges from several hundreds of nanometres down to individual molecules. The flexibility of this process permits the creation of structures with resolutions from the millimetre size range (e.g. sensors) down to the 100nm or even lower size range (e.g. quantum devices). This makes the connection between the macroscopic and the nanoscale world possible in one process step. Another result that could be observed is that it is possible to arrange particle chains of different particle densities closely beside one another.

For the fabrication of electronic nanostructures, it is desirable that the charging process should neither destroy nor contaminate the substrate surface. Provided that one chooses the correct material combination, e.g., a sufficiently hard material is pressed against a softer surface, then the surface will elastically deform without permanent deformation, provided the contact pressure is sufficiently low. A hard material will not damage the substrate since the harmless contact is just sufficient to create the charge pattern and no forces will be applied. Actually, creating surface defects, e.g. scratches, will ruin the effect of contact charging. With a softer material, i.e. where the bonds between the surface and the bulk atoms are not strong, it is possible that material might remain on the surface after the contact.

The limitations for structural resolution of the method for fabricating distinct structures on a surface are mainly given by the number of charges stored in the surface, the number of particles deposited, and the electrical mobility of the particles. The electrical mobility is a function of the particle size, the number of charges carried by the particle and the medium the particle is suspended in.

This invention finds particular application in circumventing the limits of conventional photolithography. As circuits get ever smaller, the number of layers of metal lines (called vias) used to connect the devices on the chip increases, becoming one of the largest components of the cost of chip manufacture. Each layer of metal requires a separate lithographic step, where photoresist is applied, exposed, and developed, followed by evaporation of metal, and finally lift-off of excess metal. Here, it permits the fabrication of leads with nanometre dimension without any lithography step and without destroying the underlying structure.

Even the subsequent deposition of different material or different material sizes is possible by first creating a charge pattern and deposition of one sort of particles followed by a second charge pattern creation and another particle deposition. Here, a fixation step for the initially deposited particles might be necessary, such as annealing.

The present invention may also be utilised to replace the very fine lithography employed in making chemical or biological sensors. It may also be used for fabricating catalytic structures.

Optical detectors with sub-picosecond response times have been made with (very slow) electron beam lithography and metallisation. In this way, interdigitated Metal-Semiconductor-Metal junctions are formed with lateral metal-metal spacing of below 50nm. With method of this invention, an entire optoelectronic device may be fabricated very efficiently, such as optoelectronic components based on nanoparticles. For some of these, ordering of the particles on the scale of the wavelength of the light is crucial. Among such components are quantum dot based laser and light emitting diodes.

The method may also be used in photonic bandgap materials - particles placed in arrays ordered on the scale of the wavelength of light which exhibit a band gap for the photons, so that some wavelengths are not permitted to pass. This has applications in optical communication.

The invention also finds application in the fabrication of interference colouring and anti-reflective coatings and for the construction of nanostructured surface, which exhibit unique tribological properties, such as wear resistance.

Further application could be found in the fabrication of magnetic storage devices, flash memory devices, electroluminescence displays. Also for the controlled seeding of the growth of nanotubes and nanowhiskers, the present invention can be applied.

Additionally, projecting neutral particles with a higher speed towards surface regions charged by the method would lead to a charge transfer from the surface to the particles permitting particles scattered by the surface to acquire a charge.

The invention also finds application in the removal of particles from a gas or a liquid.

Referring now to Figure 10, this shows examples of Coulomb - blockade devices created by the method in accordance with the invention. Figure 10a shows chains of nanoparticles 100 forming wireless single-electron logic based on electrons hopping between nanoparticles. Figure 10b shows single electron transistor structures with central nanoparticles 100, 102 influenced by electrodes 104, 106.

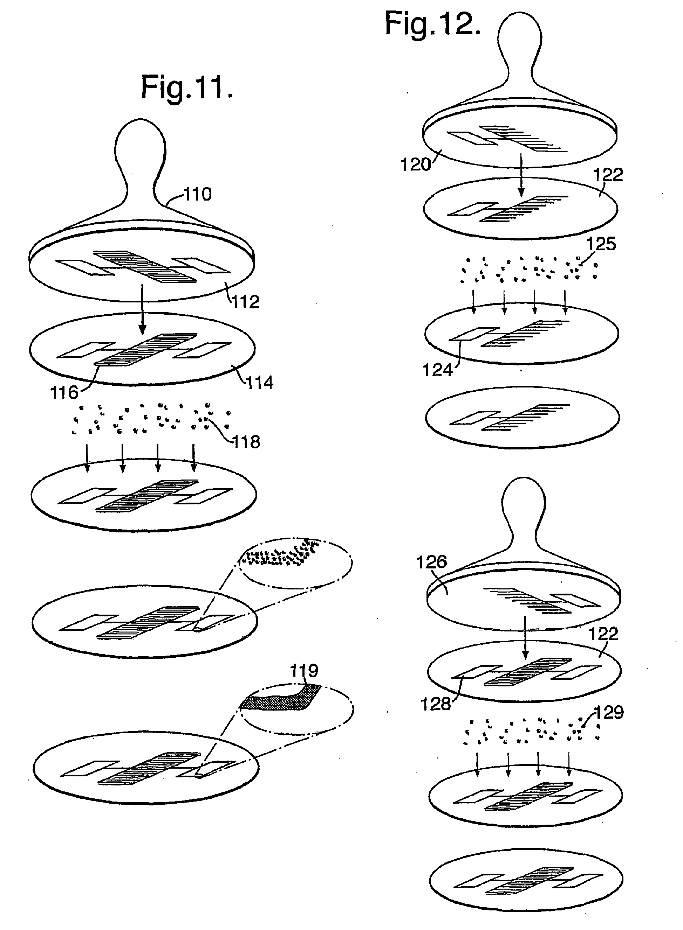

Figure 11 is a schematic diagram of the method in accordance with the invention applied to fabricating nanometer-size metallic circuit structures. A stamp 110 (shown conceptually) having a predetermined shape 112 is pressed against a substrate 114 to create a corresponding pattern of charged regions 116. Metallic particles 118 of an opposite charge type are then deposited on the substrate to adhere to the pattern 116. After an annealing step, the particles merge to form continuous metallic features 119.

Referring now to Figure 12 this shows creation of multi-metallic surface structures by controlled nanoparticle deposition in accordance with the invention. A stamp 120 is pressed against a substrate 122 to form a pattern of charged regions 124 on the substrate, on which oppositely charged nanoparticles 125 are deposited. The particles are then fixed on to the substrate by a suitable process. A further stamp 126 with a different stamp pattern is pressed against substrate 122 to produce a second pattern 128 of charged regions. This permits nanoparticles 129 of a different type to land on the second charged region.

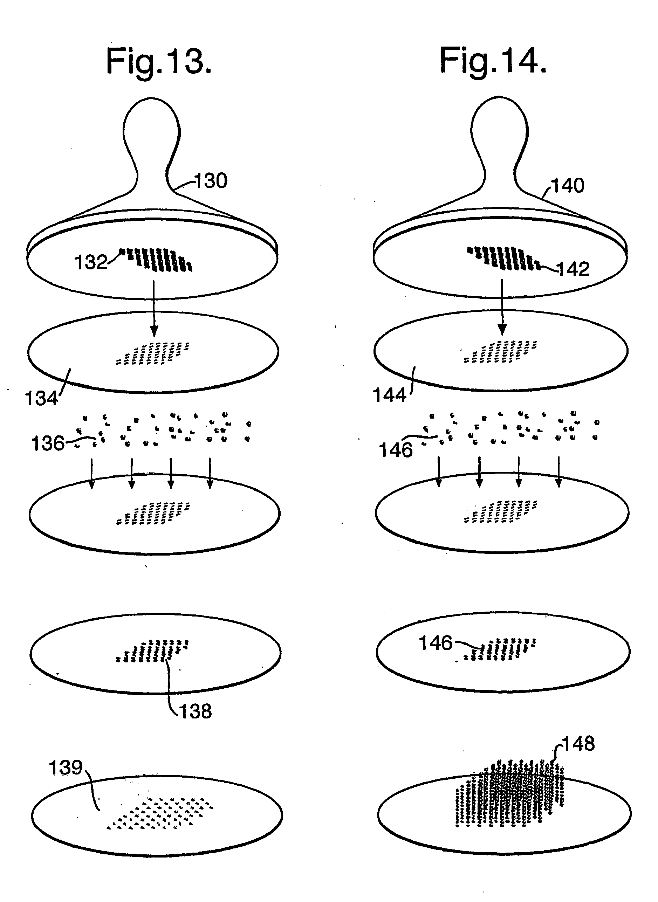

Referring to Figure 13, showing the fabrication of quantum-dot lasers by the method in accordance with the invention, wherein stamp 130 with metallised protrusions 132, having dimensions of less then 20 nanometers, is pressed against a substrate 134. The material of the substrate is in this example the n-type part of a laser structure; alternatively the substrate may constitute the p-type part of the laser. The metallised protrusions create charged regions or spots on the substrate to permit particles 136 to be deposited on the localised charge regions to create a pattern of n-type laser-active quantum dots 138. After epitaxial overgrowth of the particles as at 139 with a p-type substrate to create the laser structure, the system is ready for final processing.

The procedures of Figures 12 and 13 may be essentially combined, in that repeated operations of depositing p- or n- type particles, forming parts of laser structures, can be carried out, each operation employing particles of a different diameter, and hence laser characteristics, e.g. wavelength.. Finally, an epitaxial overgrowth is carried out, as in Figure 13.

Referring now to Figure 14, there is shown the fabrication of photonic band gap materials by a method in accordance with the invention wherein a stamp 140 having metallised protrusions 142 with lateral dimensions of the order of one quarter of the wavelength of the light in question (for example about 10 micrometers) is pressed against a substrate 144 to create charged regions of a similar pattern. Micrometer sized particles 146 are then deposited on the substrate to accumulate on the locally charged regions. By prolonged deposition, particles will land on top of each other to create filaments 148 or chains of particles. This creates filaments in a desired lattice structure having dimensions of the order of the wavelength of light, whereby to create, by Bragg reflection, photonic band gaps for transmitted light.

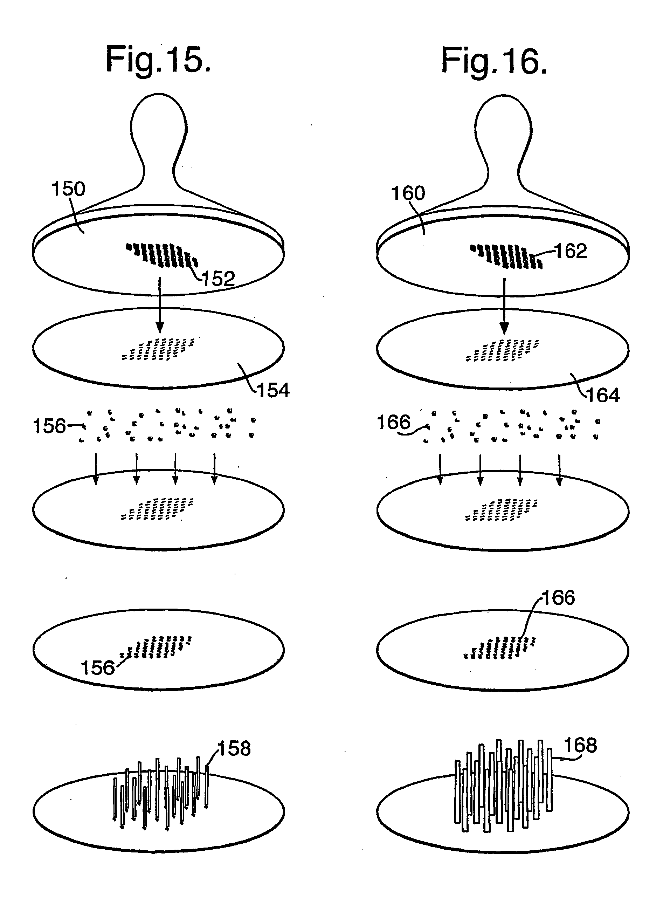

Referring to Figure 15, there is shown the fabrication of nanotube arrays by the method in accordance with the invention, wherein a stamp 150 with protrusions 152 having lateral dimensions less than 20 nanometers is pressed against a substrate 154 to create locally charged regions. Nanometer sized particles 156 of the opposite charge type deposited on the substrate to adhere to the locally charged regions. Using the nanoparticles as seeds, arrays or filaments of carbon nanotubes 158 can be grown by chemical vapour deposition methods. This has application in field emission applications.

Referring to Figure 16, there is shown the fabrication of nanorod arrays by the method in accordance with the invention, wherein a stamp 160 with protrusions 162 having lateral dimensions of less than 20 nanometers is pressed against a substrate 164 to create locally charged regions. Nanometer sized particles 166 are deposited on the locally-charged regions, and these particles are used as seeds to create filaments or nanorods, for example semiconducting or magnetic materials, which are grown by chemical vapour deposition methods.

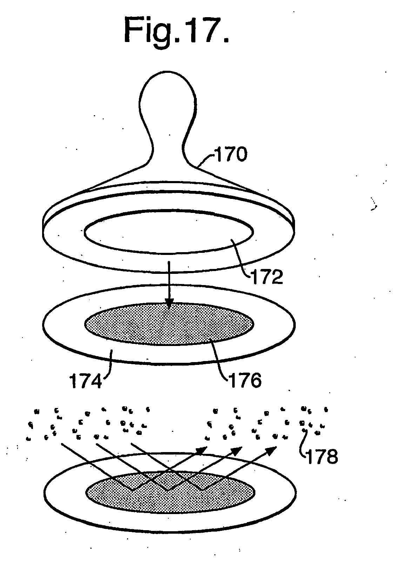

Referring to Figure 17, there is shown a method of electrically charging of aerosol particles. A stamp 170 having metallised protrusions with lateral dimensions of the order of centimetres 172 is pressed against a substrate 174 to create a charged region 176. Neutral aerosol particles are directed to the surface at high speed, thus rebounding on the substrate and taking away respective charged units from the charged region 176. Alternatively the substrate may not be electrically charged. The aerosol particles are nevertheless effective to "extract" electrical charge from the substrate by the impaction process.

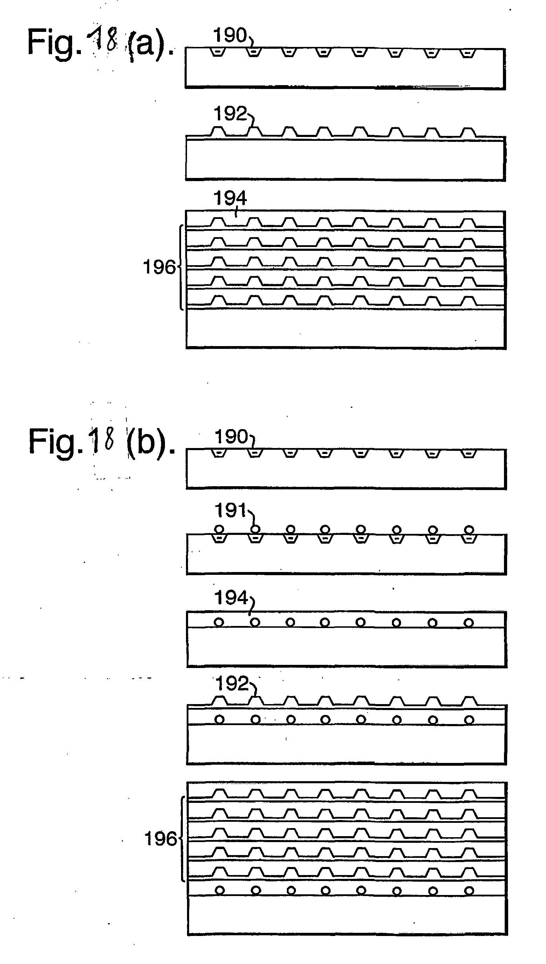

Referring now to Figure 18, there is shown a method of seeding epitaxial self-assembled dots for two and three dimensional arrays of quantum dots, by the method in accordance with the invention. As shown in Figure 18a locally charged regions 190 are created by the method in accordance with the invention. Using an epitaxial method, self-assembled dots 192 are formed on the locally charged dots. The epitaxial method may be molecular beam, a chemical beam or metal-organic vapour phased epitaxy, or any combination thereof. An insulating layer 194 is then grown over particles 192, and this process is repeated to create three dimensional arrays 196 of quantum dots.

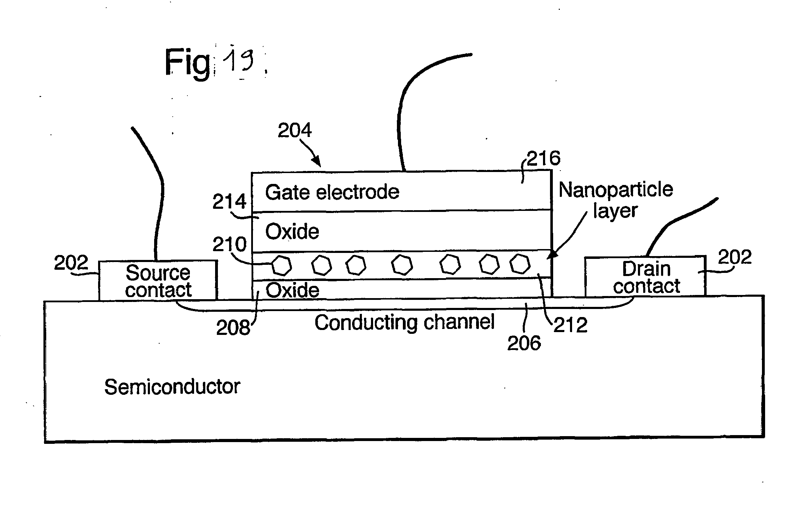

In Figure 18b the method is somewhat similar to that shown in Figure 18a and similar parts denoted by the same reference numeral. However, in an initial step nanoparticles, for example tungsten, 191 are deposited on the electrically charged arrays by the method in accordance with the invention. Using an epitaxial method, a thin buffer layer 194 is grown to cover the particles. In the next epitaxial step, self-assembled dots 192 are formed on top of the embedded particles as described in the rest of Figure 19a. A prolonged epitaxial process will create three dimensional arrays 196 of quantum dots.

Referring to Figure 19, a flash memory structure comprises a substrate 200 with source and drain electrodes 202. A gate structure 204 overlies a conducting channel 206. The gate structure comprises an oxide layer 208, a nanoparticle layer comprising nanoparticles 210 in an epitaxial overgrowth 212, and a further oxide layer 214, with a final metallic gate electrode 216. The nanoparticles 210 have the capacity for charge storage, and may be of any suitable material. In the formation of the structure, the oxide layer 208 is initially grown over the surface of the substrate, and then the nanoparticles are applied by the stamp process, as above. Successive further steps of epitaxial overgrowth and selective etching create the structure shown.

## Claims

1. A method for creating nanostructures on a surface (1) of a first material on a semiconductor substrate **characterised by** the steps of:
forming one or more electrically-charged regions (5) of predetermined shape on the surface (1), by contacting portions of the surface (1) corresponding to said regions (5) with a tool means (9) so as to transfer electric charge between said tool means (9) and said portions of the surface (1);
providing particles (7) of a second material; and
permitting the particles (7) to flow in the vicinity of said regions, whereby the particles (7) are either attracted to, or repelled from, said one or more electrically charged regions owing to the polarity of the particles (7) as regard to the polarity of electrically charged region (5).

2. A method according to claim 1, wherein said particles (7) are of nanometric dimensions.

3. A method according to any preceding claim, wherein the second material is different from the first material.

4. A method according to any preceding claim, wherein said one or more electrically charged regions (5) are charged with a charge of a first sign, and the particles (7) of the second material are charged with charge of a second sign, the second sign being opposite to that of the first sign.

5. A method according to any of claims 1 to 3, wherein said one or more electrically charged regions (5) are charged with a charge of a first sign, and the particles (7) of the second material are charged with a charge of a second sign, the second sign being the same as that of the first.

6. A method according to claims 4 or 5, wherein said particles (7) of a second material each carry one or more electric charges.

7. A method according to any preceding claim, wherein an electric field is provided in a direction towards said surface (1) so as to enhance the flow of said particles (7) towards said surface (1).

8. A method according to claim 7, wherein the electric field induces a charge polarisation of said particles (7), which is effective to deposit the particles on the surface.

9. A method according to any preceding claim, wherein said particles are deposited on the surface in areas determined by said one or more electrically charged regions (5).

10. A method according to claim 9, wherein the particles (7) are deposited on said portions of the surface (1) corresponding to said one or more electrically-charged regions (5).

11. A method according to claim 9, wherein the particles are deposited on said surface on areas other than said portions of the surface (1) corresponding to said one or more electrically-charged regions (5).

12. A method according to any of claims 1 to 3, wherein said particles (7) of a second material are electrically neutral, and are projected against charged regions (176) of a substrate surface (174) to absorb electrical charge, and to rebound from said substrate surface (174) in an electrically-charged condition (178).

13. A method according to any preceding claim, wherein the tool means (9) comprises a stamp (110,120,126, 130,140,150) having a contoured surface, for contacting the surface (1) of the first material, with a configuration conforming to the shape of said electrically charged regions (5).

14. A method according to any of claims 1 or 12, wherein the tool means (9) comprises an elongate object such as a needle or rod which is pressed against the surface (1) of the first material and drawn across the surface (1) in a desired path to define said electrically charged regions (5).

15. A method according to claim 14, wherein the tool means (9) is the tip of a scanning probe microscope.

16. A method according to any preceding claim, wherein said surface (1) is prepared so as to have no significant water or other conductive contamination.

17. A method according to any preceding claims, wherein said particles (7) of a second material are arranged to flow as an aerosol.

18. A method according to any of claims 1 to 16, wherein said particles (7) of a second material are arranged to flow as a suspension in a liquid.

19. A method according to any preceding claim, wherein the second material is metallic, and the particles (7) are deposited on the surface (1) of the first material and subsequently annealed to the surface (1).

20. A method according to any preceding claim, wherein in a second stage of the method, the steps set forth in claim 1 are repeated with a different one or more electrically-charged regions (128) of a different predetermined shape or size.

21. A method according to any of claims 1 to 18, including a further step of epitaxial overgrowth (139) of the particles (7) of the second material, and wherein the first material, the particles (7) of the second material, and material of said epitaxial overgrowth form a laser structure.

22. A method according to claims 20 and 21, wherein additional particles are deposited in subsequent steps, each step using particles of different size.

23. A method according to any of claims 1 to 18, including depositing said particles (7) of a second material on the surface (1) of the first material for a prolonged period to create filaments (148, 158) comprising the second material upstanding from the surface.

24. A method as claimed in any preceding claim, including providing a voltage bias between said tool means (9) and said surface (1).

25. A method according to any of claims 1 to 18, further comprising the steps of:
forming on said one or more electrically charged regions self assembled dots (192) by an epitaxial method, whereby the self assembled dots (192) are epitaxially connected to the surface (1);
growing an intermediate layer on the self assembled dots (192); and
repeating the steps of forming self assembled dots and growing an intermediate layer a desired number of times (196).

26. Apparatus for creating nanostructures on a semiconductor surface (1), **characterised by** tool means (9) for contacting portions of the surface (1) of a first material in order to transfer electric charge thereto and to form one or more electrically-charge regions (5), and a system constructed to permit particles (7) of a second material to flow in the vicinity of said one or more electrically-charged regions (5), to interact in a predetermined manner with said one or more electrically-charged regions (5).

27. Apparatus according to claim 26, including aerosol means for producing particles of nanometric dimensions.

28. Apparatus according to claim 27, wherein said aerosol means is arranged to electrically charge said particles.

29. Apparatus according to any of claims 26-28, including means (26) for producing an electric field in a direction towards said surface so as to enhance the flow of said particles towards said surface.

30. Apparatus according to any of claims 26-29, wherein the tool means (9) comprises a stamp (110, 120, 126, 130, 140, 150) having a contoured surface, for contacting the surface (1) of the first material, with a configuration conforming to the shape of said electrically charged regions (5).

## Patentansprüche

1. Verfahren zum Erzeugen von Nanostrukturen auf einer Oberfläche (1) eines ersten Materials auf einem Halbleitersubstrat, das **gekennzeichnet ist durch** die folgenden Schritte:
Bilden eines oder mehrerer elektrisch geladener Bereiche (5) einer vorgegebenen Form auf der Oberfläche (1) **durch** Kontaktieren von Abschnitten der Oberfläche (1), die den Bereichen (5) entsprechen, mit Werkzeugmitteln (9), so dass elektrische Ladung zwischen den Werkzeugmitteln (9) und den Abschnitten der Oberfläche (1) übertragen wird;
Bereitstellen von Teilchen (7) eines zweiten Materials; und
Zulassen, dass die Teilchen (7) in die Nähe der Bereiche fließen, wodurch die Teilchen (7) infolge der Polung der Teilchen (7) und deren Beziehung zu der Polung eines elektrisch geladenen Bereichs (5) entweder von dem einen oder den mehreren elektrisch geladenen Bereichen angezogen oder abgestoßen werden.

2. Verfahren nach Anspruch 1, wobei die Teilchen (7) Nanometer-Abmessungen haben.

3. Verfahren nach einem der vorhergehenden Ansprüche wobei sich das zweite Material von dem ersten Material unterscheidet.

4. Verfahren nach einem der vorhergehenden Ansprüche, wobei der eine oder die mehreren elektrisch geladenen Bereiche (5) mit einer Ladung eines ersten Vorzeichens geladen sind und die Teilchen (7) des zweiten Materials mit einer Ladung eines zweiten Vorzeichens geladen sind, wobei das zweite Vorzeichen dem ersten Vorzeichen entgegengesetzt ist.

5. Verfahren nach einem der Ansprüche 1 bis 3, wobei der eine oder die mehreren elektrisch geladenen Bereiche (5) mit einer Ladung eines ersten Vorzeichens geladen sind und die Teilchen (7) des zweiten Materials mit einer Ladung eines zweiten Vorzeichens geladen sind, wobei das zweite Vorzeichen das gleiche ist wie das erste Vorzeichen.

6. Verfahren nach Anspruch 4 oder 5, wobei die Teilchen (7) des zweiten Materials jeweils eine oder mehrere elektrische Ladungen tragen.

7. Verfahren nach einem der vorhergehenden Ansprüche, wobei ein elektrisches Feld in einer Richtung zu der Oberfläche (1) hin bereitgestellt wird, so dass der Fluss der Teilchen (7) zu der Oberfläche (1) hin verstärkt wird.

8. Verfahren nach Anspruch 7, wobei das elektrische Feld eine Ladungspolarisation der Teilchen (7) induziert, die wirksam ist, um die Teilchen auf der Oberfläche abzulagern.

9. Verfahren nach einem der vorhergehenden Ansprüche, wobei die Teilchen auf der Oberfläche in Gebieten abgelagert werden, die durch den einen oder die mehreren elektrisch geladenen Bereiche (5) bestimmt werden.

10. Verfahren nach Anspruch 9, wobei die Teilchen (7) auf der Oberfläche in den Abschnitten der Oberfläche (1), die dem einen oder den mehreren elektrisch geladenen Bereichen (5) entsprechen, abgelagert werden.

11. Verfahren nach Anspruch 9, wobei die Teilchen auf der Oberfläche in anderen Gebieten als den Abschnitten der Oberfläche (1), die dem einen oder den mehreren elektrisch geladenen Bereichen (5) entsprechen, abgelagert werden.

12. Verfahren nach einem der Ansprüche 1 bis 3, wobei die Teilchen (7) des zweiten Materials elektrisch neutral sind und gegen geladene Bereiche (176) der Substratoberfläche (174) geworfen werden, um elektrische Ladung zu absorbieren und von der Substratoberfläche (174) in einem elektrisch geladenen Zustand (178) abzuprallen.

13. Verfahren nach einem der vorhergehenden Ansprüche, wobei die Werkzeugmittel (9) einen Stempel (110, 120, 126, 130, 140, 150), der eine konturierte Oberfläche besitzt, zum Kontaktieren der Oberfläche (1) des ersten Materials mit einer Anordnung, die der Form der elektrisch geladenen Bereiche (5) entspricht, umfassen.

14. Verfahren nach einem der Ansprüche 1 oder 12, wobei die Werkzeugmittel (9) ein längliches Objekt wie etwa eine Nadel oder einen Stab, das gegen die Oberfläche (1) des ersten Materials gedrückt wird und über die Oberfläche (1) auf einem gewünschten Weg gezogen wird, um die elektrisch geladenen Bereiche (5) zu definieren, umfassen.

15. Verfahren nach Anspruch 14, wobei das Werkzeugmittel (9) die Spitze eines Rastersondenmikroskops ist.

16. Verfahren nach einem der vorhergehenden Ansprüche, wobei die Oberfläche (1) so präpariert ist, dass sie keine signifikante Kontamination mit Wasser oder anderen leifähigen Verunreinigungen aufweist.

17. Verfahren nach einem der vorhergehenden Ansprüche, wobei die Teilchen (7) des zweiten Materials dazu ausgelegt sind, als ein Aerosol zu fließen.

18. Verfahren nach einem der Ansprüche 1 bis 16, wobei die Teilchen (7) des zweiten Materials dazu ausgelegt sind, als eine Suspension in einer Flüssigkeit zu fließen.

19. Verfahren nach einem der vorhergehenden Ansprüche, wobei das zweite Material metallisch ist und die Teilchen (7) auf der Oberfläche (1) des ersten Materials abgelagert werden und anschließend in die Oberfläche eingebrannt (1) werden.

20. Verfahren nach einem der vorhergehenden Ansprüche, wobei in einer zweiten Stufe des Verfahrens die Schritte, die in Anspruch 1 dargelegt sind, mit einem oder mehreren anderen elektrisch geladenen Bereichen (128) mit einer anderen vorgegebenen Form und Größe wiederholt werden.

21. Verfahren nach einem der Ansprüche 1 bis 18, das einen weiteren Schritt des epitaktischen Aufwachsens (139) der Teilchen (7) des zweiten Materials umfasst, wobei das erste Material, die Teilchen (7) des zweiten Materials und Material aus dem epitaktischen Aufwachsen eine Laserstruktur bilden.

22. Verfahren nach den Ansprüchen 20 und 21, wobei zusätzliche Teilchen in nachfolgenden Schritten abgelagert werden, wobei jeder Schritt Teilchen einer anderen Größe verwendet.

23. Verfahren nach einem der Ansprüche 1 bis 18, das ein Ablagern der Teilchen (7) eines zweiten Materials auf der Oberfläche (1) des ersten Materials über einen ausgedehnten Zeitraum umfasst, um Filamente (148, 158), die aus dem zweiten Material, das von der Oberfläche absteht, bestehen, herzustellen.

24. Verfahren nach einem der vorhergehenden Ansprüche, das das Bereitstellen einer Vorspannung zwischen den Werkzeugmitteln (9) und der Oberfläche (1) umfasst.

25. Verfahren nach einem der Ansprüche 1 bis 18, das ferner die folgenden Schritte umfasst:
Bilden von selbstorganisierten Punkten (192) auf dem einen oder den mehreren elektrisch geladenen Bereichen durch ein epitaktisches Verfahren, wobei die selbstorganisierten Punkte (192) epitaktisch mit der Oberfläche (1) verbunden sind;
Aufwachsen einer Zwischenschicht auf den selbstorganisierten Punkten (192); und
Wiederholen der Schritte des Bildens von selbstorganisierten Punkten und des Aufwachsens einer Zwischenschicht für eine gewünschte Anzahl von Wiederholungen (196).

26. Vorrichtung zum Erzeugen von Nanostrukturen auf einer Halbleiteroberfläche (1), die **gekennzeichnet ist durch**: Werkzeugmittel (9) zum Kontaktieren von Abschnitten der Oberfläche (1) eines ersten Materials, um elektrische Ladung darauf zu übertragen und einen oder mehrere elektrisch geladene Bereiche (5) zu bilden, und ein System, das dazu ausgelegt ist, zuzulassen, dass Teilchen (7) eines zweiten Materials in die Nähe der elektrisch geladenen Bereiche strömen, um auf eine vorgegebene Weise mit dem einen oder den mehreren elektrisch geladenen Bereichen (5) in Wechselwirkung zu treten.

27. Vorrichtung nach Anspruch 26, die Aerosol-Mittel umfasst, um Teilchen mit Nanometer-Abmessungen herzustellen.

28. Vorrichtung nach Anspruch 27, wobei die Aerosol-Mittel dazu ausgelegt sind, die Teilchen elektrisch zu laden.

29. Vorrichtung nach einem der Ansprüche 26-28, die Mittel (26) umfasst, um ein elektrisches Feld in einer Richtung zu der Oberfläche hin zu erzeugen, so dass der Fluss der Teilchen zu der Oberfläche hin verstärkt wird.

30. Vorrichtung nach einem der Ansprüche 26-29, wobei die Werkzeugmittel (9) einen Stempel (110, 120, 126, 130, 140, 150), der eine konturierte Oberfläche besitzt, zum Kontaktieren der Oberfläche (1) des ersten Materials mit einer Anordnung, die der Form der elektrisch geladenen Bereiche (5) entspricht, umfassen.

## Revendications

1. Procédé de création de nanostructures sur une surface (1) d'un premier matériau sur un substrat semiconducteur, **caractérisé par** les étapes consistant à :
former une ou plusieurs régions chargées électriquement (5) de forme prédéterminée sur la surface (1), en mettant en contact des parties de la surface (1) correspondant auxdites régions (5) avec un moyen formant outil (9) de manière à transférer une charge électrique entre ledit moyen formant outil (9) et lesdites parties de la surface (1) ;
se procurer des particules (7) d'un deuxième matériau ; et
permettre aux particules (7) de s'écouler à proximité desdites régions, les particules (7) étant attirées vers ou repoussées depuis ladite ou lesdites régions chargées électriquement en raison de la polarité des particules (7) par rapport à la polarité d'une région chargée électriquement (5).

2. Procédé selon la revendication 1, dans lequel lesdites particules (7) sont de dimensions nanométriques.

3. Procédé selon l'une quelconque des revendications précédentes, dans lequel le deuxième matériau est différent du premier matériau.

4. Procédé selon l'une quelconque des revendications précédentes, dans lequel ladite ou lesdites régions chargées électriquement (5) sont chargées avec une charge d'un premier signe, et les particules (7) du deuxième matériau sont chargées avec une charge d'un deuxième signe, le deuxième signe étant opposé au premier signe.

5. Procédé selon l'une quelconque des revendications 1 à 3, dans lequel ladite ou lesdites régions chargées électriquement (5) sont chargées avec une charge d'un premier signe, et les particules (7) du deuxième matériau sont chargées avec une charge d'un deuxième signe, le deuxième signe étant identique au premier signe.

6. Procédé selon la revendication 4 ou 5, dans lequel lesdites particules (7) d'un deuxième matériau portent chacune une ou plusieurs charges électriques.

7. Procédé selon l'une quelconque des revendications précédentes, dans lequel un champ électrique est appliqué dans une direction vers ladite surface (1) de manière à améliorer l'écoulement desdites particules (7) vers ladite surface (1).

8. Procédé selon la revendication 7, dans lequel le champ électrique induit une polarisation de la charge desdites particules (7), qui est efficace pour déposer les particules sur la surface.

9. Procédé selon l'une quelconque des revendications précédentes, dans lequel lesdites particules sont déposées sur la surface dans des zones déterminées par ladite ou lesdites régions chargées électriquement (5).

10. Procédé selon la revendication 9, dans lequel les particules (7) sont déposées sur lesdites parties de la surface (1) correspondant à ladite ou lesdites régions chargées électriquement (5).

11. Procédé selon la revendication 9, dans lequel les particules sont déposées sur ladite surface sur d'autres zones que lesdites parties de la surface (1) correspondant à ladite ou lesdites régions chargées électriquement (5).

12. Procédé selon l'une quelconque des revendications 1 à 3, dans lequel lesdites particules (7) d'un deuxième matériau sont électriquement neutres, et sont projetées contre des régions chargées (176) d'une surface de substrat (174) pour absorber une charge électrique, et pour rebondir depuis ladite surface de substrat (174) dans un état chargé électriquement (178).

13. Procédé selon l'une quelconque des revendications précédentes, dans lequel le moyen formant outil (9) comprend un poinçon (110, 120, 126, 130, 140, 150) ayant une surface profilée, pour entrer en contact avec la surface (1) du premier matériau, avec une configuration s'adaptant à la forme desdites régions chargées électriquement (5).

14. Procédé selon l'une quelconque des revendications 1 à 12, dans lequel le moyen formant outil (9) comprend un objet allongé tel qu'une aiguille ou une tige qui est appuyé contre la surface (1) du premier matériau et tiré à travers la surface (1) en un chemin souhaité pour définir les régions chargées électriquement (5).

15. Procédé selon la revendication 14, dans lequel le moyen formant outil (9) est la pointe d'un microscope à sonde de balayage.

16. Procédé selon l'une quelconque des revendications précédentes, dans lequel ladite surface (1) est préparée de manière à ne présenter aucune contamination par l'eau ou autre contamination conductrice importante.

17. Procédé selon l'une quelconque des revendications précédentes, dans lequel lesdites particules (7) d'un deuxième matériau sont configurées pour s'écouler comme un aérosol.

18. Procédé selon l'une quelconque des revendications 1 à 16, dans lequel lesdites particules (7) d'un deuxième matériau sont configurées pour s'écouler comme une suspension dans un liquide.

19. Procédé selon l'une quelconque des revendications précédentes, dans lequel le deuxième matériau est métallique, et les particules (7) sont déposées sur la surface (1) du premier matériau puis fixées par recuit à la surface (1).

20. Procédé selon l'une quelconque des revendications précédentes, dans lequel dans une deuxième phase du procédé, les étapes indiquées dans la revendication 1 sont répétées avec une ou plusieurs régions chargées électriquement différentes (128) d'une forme ou taille prédéterminée différente.

21. Procédé selon l'une quelconque des revendications 1 à 18, comprenant une étape supplémentaire de surcroissance épitaxiale (139) des particules (7) du deuxième matériau, et dans lequel le premier matériau, les particules (7) du deuxième matériau et le matériau de ladite surcroissance épitaxiale forment une structure de laser.

22. Procédé selon les revendications 20 et 21, dans lequel des particules supplémentaires sont déposées lors d'étapes ultérieures, chaque étape utilisant des particules de taille différente.

23. Procédé selon l'une quelconque des revendications 1 à 18, comprenant le dépôt desdites particules (7) d'un deuxième matériau sur la surface (1) du premier matériau pendant une période prolongée pour créer des filaments (148, 158) comprenant le deuxième matériau dressés depuis la surface.

24. Procédé selon l'une quelconque des revendications précédentes, comprenant l'application d'une polarisation de tension entre ledit moyen formant outil (9) et ladite surface (1).

25. Procédé selon l'une quelconque des revendications 1 à 18, comprenant en outre les étapes consistant à :
former sur ladite ou lesdites régions chargées électriquement des points auto-assemblés (192) par un procédé épitaxial, les points auto-assemblés (192) étant reliés de façon épitaxiale à la surface (1) ;
faire croître une couche intermédiaire sur les points auto-assemblés (192) ; et
répéter les étapes de formation de points auto-assemblés et de croissance d'une couche intermédiaire un nombre souhaité de fois (196).

26. Appareil pour créer des nanostructures sur une surface semi-conductrice (1), **caractérisé par** un moyen formant outil (9) pour entrer en contact avec des parties de la surface (1) d'un premier matériau afin d'y transférer une charge électrique et de former une ou plusieurs régions chargées électriquement (5), et un système construit pour permettre à des particules (7) d'un deuxième matériau de s'écouler à proximité desdites régions chargées électriquement, pour interagir d'une manière prédéterminée avec ladite ou lesdites régions chargées électriquement (5).

27. Appareil selon la revendication 26, comprenant un moyen formant aérosol pour produire des particules de dimensions nanométriques.

28. Appareil selon la revendication 27, dans lequel ledit moyen formant aérosol est configuré pour charger électriquement lesdites particules.

29. Appareil selon l'une quelconque des revendications 26 à 28, comprenant un moyen (26) pour produire un champ électrique dans une direction vers ladite surface de manière à améliorer l'écoulement desdites particules vers ladite surface.

30. Appareil selon l'une quelconque des revendications 26 à 29, dans lequel le moyen formant outil (9) comprend un poinçon (110, 120, 126, 130, 140, 150) ayant une surface profilée, pour entrer en contact avec la surface (1) du premier matériau, avec une configuration s'adaptant à la forme desdites régions chargées électriquement (5).
